# FASCICULE DE BREVET EUROPEEN

(11) **EP 0 403 350 B1**
(45) Date de publication et mention de la délivrance du brevet: **07.09.1994**
(21) Numéro de dépôt: 90401590.6
(22) Date de dépôt: 11.06.1990
(51) Int. Cl.: H05K 13/06, H01B 13/00, H01R 43/28

(54) **Procédé et dispositif pour la réalisation de pièces de câblage**
Verfahren und Vorrichtung für die Herstellung von Kabelbäumen
Process and device for manufacturing cable harnesses

(30) Priorité: 15.06.1989 FR 8907972
(43) Date de publication de la demande: 19.12.1990
(73) Titulaire: EUROCOPTER FRANCE, F-13725 Marignane Cédex (FR)
(72) Inventeur: Cerda, Léon Germain, F-13620 Carry-Le-Rouet (FR)
(74) Mandataire: Bonnetat, Christian

(56) Documents cités:
- EP-A- 0 182 591
- GB-A- 2 087 760
- US-A- 4 835 858

## Description

La présente invention concerne un procédé et un dispositif pour la réalisation d'une pièce de câblage comportant une pluralité de conducteurs et de connecteurs, lesdits connecteurs étant chacun pourvus d'emplacements de branchement pour des extrémités de conducteurs et occupant des positions géographiques déterminées, tandis que chaque conducteur suit un cheminement également déterminé à l'intérieur de ladite pièce de câblage pour relier un emplacement de branchement d'un connecteur à un emplacement de branchement d'un autre connecteur, les cheminements desdits conducteurs présentant des portions communes le long desquelles lesdits conducteurs sont rendus solidaires les uns des autres en formant des faisceaux.

Un tel procédé et un tel dispositif sont connus du fascicule de brevet GB-A-2 087 760.

L'invention s'applique, plus particulièrement quoique non exclusivement, à la réalisation de pièces de câblage pour aéronefs, et notamment pour hélicoptères, dans lesquels lesdites pièces devant relier entre eux les nombreux équipements électriques et électroniques nécessaires au pilotage desdits appareils et à l'exécution des différentes missions qu'ils doivent effectuer, sont très complexes et variées.

Avant d'installer lesdites pièces de câblage, par exemple dans un aéronef qu'elles doivent équiper, il est nécessaire de mettre en forme lesdites pièces, conformément à l'agencement interne de l'aéronef, sur de longues tables (jusqu'à une dizaine de mètres de longueur), chaque conducteur s'étendant, sur la table, entre des positions d'entrée et de sortie spécifiques, en suivant un cheminement prédéterminé.

Actuellement, les cheminements des différents conducteurs constituant la pièce de câblage sont représentés graphiquement sur une feuille de papier disposée sur la table, sous une plaque transparente munie d'une pluralité de trous destinés à recevoir des pions de guidage pour le maintien en place provisoire des conducteurs le long de leur cheminement.

Pour chaque conducteur à mettre en place, l'opérateur doit tout d'abord identifier celui-ci, puis, à l'aide d'une documentation technique, rechercher, parmi la pluralité de cheminements représentés, celui qui correspond au conducteur qu'il vient d'identifier. L'opérateur peut alors mettre en place le conducteur en suivant le tracé de son cheminement, et en l'y maintenant à l'aide de pions de guidage disposés, par l'opérateur, en des endroits appropriés du trace. L'opérateur doit bien sûr recommencer cet ensemble d'opérations pour chaque conducteur de la pièce.

Un tel travail est bien évidemment fastidieux, et des erreurs sont quasiment inévitables, compte tenu, d'une part, de la longueur des tables et, d'autre part, du fait que la réalisation de telles pièces de câblage peut mettre en oeuvre plusieurs centaines de conducteurs. Même si un "canevas" de la pièce est représenté sur la table, l'opérateur se retrouve en fait devant un véritable "fouillis" de conducteurs entrelacés difficile à maîtriser.

La présente invention a pour but d'éviter ces inconvénients, et concerne un procédé et un dispositif permettant de réaliser automatiquement de telles pièces de câblage.

A cette fin, selon l'invention, le procédé pour la réalisation d'une pièce de câblage comportant une pluralité de conducteurs et de connecteurs, lesdits connecteurs étant chacun pourvus d'emplacements de branchement pour des extrémités de conducteurs et occupant dans ladite pièce de câblage des positions géographiques déterminées, tandis que chaque conducteur suit un cheminement déterminé à l'intérieur de ladite pièce de câblage pour relier un emplacement de branchement d'un connecteur à un emplacement de branchement d'un autre connecteur, les cheminements desdits conducteurs présentant des tronçons communs le long desquels lesdits conducteurs sont solidarisés les uns des autres en faisceaux, et ladite pièce de câblage présentant une structure allongée comprenant un faisceau longitudinal principal et des faisceaux latéraux reliés à celui-ci à des noeuds de jonction, est remarquable en ce que :
a) on prévoit des organes de guidage glissant, individuels et susceptibles de rassembler les conducteurs appartenant à un même faisceau et de séparer les uns des autres les conducteurs de faisceaux différents ;
b) on dispose lesdits connecteurs les uns à côté des autres, dans l'ordre dans lequel ils se trouvent le long dudit faisceau principal ;
c) on dispose les uns à côté des autres autant d'organes de guidage glissant qu'il est nécessaire pour déterminer lesdits noeuds de jonction ;
d) on connecte les extrémités de chaque conducteur aux emplacements de branchement appropriés des deux connecteurs qui doivent être reliés par ledit conducteur, en faisant passer ce conducteur par le ou les organes de guidage glissant correspondants ;
e) on écarte lesdits moyens de guidage glissant les uns des autres jusqu'à ce qu'ils viennent en coïncidence avec lesdits noeuds de jonction des faisceaux latéraux au faisceau principal et on écarte lesdits connecteurs les uns des autres jusqu'à ce que lesdits conducteurs soient tendus;
f) on rend solidaires les uns des autres les conducteurs appartenant à un même faisceau ; et
g) on dégage la pièce de câblage ainsi obtenue desdits organes de guidage glissant.

Comme on peut le voir, les différentes opérations b) à g) ci-dessus peuvent aisément être réalisées en totalité ou en partie par des robots, de sorte que, comme cela ressortira clairement de la suite, il est possible grâce à l'invention de robotiser au moins partiellement la fabrication des pièces de câblage. En effet, un conducteur étant préparé en vue de son montage, c'est-à-dire coupé à longueur avec ses extrémités dénudées de sa gaine isolante et éventuellement munies, de façon connue, de broches destinées à s'encliqueter dans les emplacements de branchement des connecteurs, peut, après identification et détermination de son cheminement - par la lecteur d'un plan ou consultation de la mémoire d'un calculateur - être connecté par un robot aux connecteurs correspondants, lesdits connecteurs et lesdits organes de guidage glissant étant eux-mêmes déplacés par des robots. On remarquera que la préparation des conducteurs peut elle-même être robotisée, lesdits conducteurs étant coupés dans des câbles continus dévidés de bobines, marqués et saisis en vue de leur branchement. La totalité du processus de réalisation d'une pièce de câblage conformément à l'invention peut donc être pilotée par un calculateur.

Dans le cas où au moins certains des faisceaux latéraux et/ou le faisceau longitudinal présentent des cheminements non rectilignes, on peut procéder à une éventuelle opération de mise en forme ultérieure desdits faisceaux, de façon que ceux-ci présentent leur forme définitive et que lesdits connecteurs viennent occuper les positions géographiques relatives qu'ils occupent dans ladite pièce de câblage.

Dans un mode de réalisation préféré il est avantageux que :
- dans l'opération b) lesdits connecteurs en position rapprochée les uns des autres forment au moins approximativement un alignement ;
- dans l'opération c) lesdits organes de guidage glissant en position rapprochée les uns des autres forment au moins approximativement un alignement ; et
- ledit alignement d'organes de guidage glissant soit disposé au moins sensiblement parallèlement audit alignement de connecteurs.

Dans ce cas, afin de simplifier la mécanisation des différentes opérations, lesdits alignements de connecteurs et d'organes de guidage glissant sont au moins sensiblement parallèles audit faisceau longitudinal principal de la pièce de câblage à obtenir. Il est alors avantageux que, dans l'opération e), l'écartement desdits organes de guidage glissant se fasse le long dudit alignement d'organes de guidage glissant, tandis que l'écartement desdits connecteurs se fait le long dudit alignement de connecteurs, ainsi que transversalement à ce dernier alignement.

On remarquera que, dans le cas où lesdits faisceaux latéraux sont répartis de part et d'autre dudit faisceau longitudinal principal, l'écartement desdits connecteurs transversalement audit alignement qu'ils forment pourrait être réalisé de part et d'autre de cet alignement, en accord avec la disposition de chaque faisceau latéral. Toutefois, toujours à des fins de simplification de la mécanisation des opérations, il est préférable que tous les connecteurs soient écartés tranversalement dudit alignement qu'ils forment, d'un même côté, la répartition des faisceaux latéraux de part et d'autre du faisceau longitudinal principal étant alors effectuée postérieurement. Ainsi, quel que soit le côté du faisceau longitudinal principal où se trouvent lesdits faisceaux latéraux, ledit écartement transversal des connecteurs est réalisé d'un seul côté dudit alignement de connecteurs, les faisceaux latéraux devant se trouver du côté opposé étant ramenés du bon côté dans une opération ultérieure.

Dans le cas d'une pièce de câblage dans laquelle au moins certains desdits faisceaux latéraux comportent des faisceaux de dérivation pourvus de connecteurs à leurs extrémités libres, il est avantageux que l'on prévoit des organes de guidage glissant supplémentaires associés aux noeuds de jonction des faisceaux de dérivation aux faisceaux latéraux, et que :
- dans l'opération b), les connecteurs reliés aux extrémités desdits faisceaux de dérivation soient intercalés parmi les connecteurs des faisceaux latéraux ;
- dans l'opération c), lesdits organes de guidage glissant supplémentaires sont disposés en position rapprochée les uns des autres en étant intercalés aux autres organes de guidage glissant ;
- dans l'opération d), on fasse passer les conducteurs concernés par les organes de guidage glissant supplémentaires ; et
- dans l'opération e), on écarte lesdits organes de guidage glissant supplémentaires les uns des autres par glissement le long desdits conducteurs jusqu'à ce qu'ils viennent en coïncidence avec lesdits noeuds de jonction entre les faisceaux de dérivation et les faisceaux latéraux.

De même que précédemment, il est préférable que, dans l'opération c), lesdits organes de guidage glissant supplémentaires se trouvent, en position rapprochée, dans un alignement, ledit alignement étant soit celui des connecteurs, soit un alignement parallèle à celui-ci et à celui des organes de guidage glissant associés aux noeuds de jonction entre les faisceaux latéraux et le faisceau principal. Alors, comme pour les organes de guidage glissant principaux et pour les mêmes raisons de simplicité, dans l'opération e), l' écartement desdits organes de guidage glissant supplémentaires se fait le long de l'alignement dans lequel ils se trouvent.

La présente invention concerne de plus un dispositif permettant de mettre en oeuvre le procédé. Un tel dispositif peut être particulièrement simple et comporter :
- un support,
- des organes de guidage glissant, individuels et susceptibles de guider les conducteurs d'une pièce de cablage et de se déplacer sur ledit support, et
- des organes pour le maintien des connecteurs de ladite pièce de cablage, lesdits organes de maintien étant susceptibles de se déplacer sur ledit support.

Il peut comporter de plus des moyens pour déplacer lesdits organes de guidage et lesdits organes de maintien des connecteurs, ainsi que des moyens pour brancher les extrémités desdits conducteurs sur les connecteurs.

Un tel support, de préférence plan, pourrait être disposé verticalement comme les supports de fabrication manuelle connus ou bien encore être incliné. Toutefois, pour des facilités de fabrication mécanique, il est avantageux que ce support se présente sous la forme d'une table horizontale. Cette table comporte alors avantageusement des moyens pour guider les déplacements desdits organes de guidage glissant et lesdits organes de maintien des connecteurs le long de trajectoires rectilignes parallèles. On peut donc réaliser ladite table sous forme d'une chaîne de transfert.

Afin d'éviter que, pendant l'opération d), les conducteurs branchés n'encombrent ledit support, il est avantageux qu'il soit tel qu'une partie importante de chaque conducteur reliée à deux connecteurs en position rapprochée ne soit pas supportée par ledit support et puisse pendre verticalement à l'extérieur de celui-ci. On voit qu'il est alors intéressant que tous les conducteurs pendent du même côté du support, ce qui dégage l'autre côté de celui-ci pour permettre l'écartement transversal ultérieur desdits connecteurs.

Lesdits organes de guidage glissant peuvent être constitués par de simples pions, utilisés par paires.

Bien entendu, le dispositif selon l'invention peut comporter des moyens pour couper à longueur, identifier et préparer chaque conducteur avant son branchement. Il peut être piloté, notamment en ce qui concerne ces derniers moyens, par les moyens de calcul prévus pour déplacer lesdits organes de guidage glissant et lesdits organes de maintien des connecteurs.

Les figures du dessin annexé feront bien comprendre comment l'invention peut être réalisée. Sur ces figures des références identiques désignent des éléments semblables.

La figure 1 montre un exemple schématique simplifié d'une pièce de câblage à réaliser conformément à l'invention.

Les figures 2 à 6 illustrent schématiquement des étapes du procédé selon l'invention pour réaliser la pièce de câblage de la figure 1.

La figure 7 montre un autre exemple schématique simplifié d'une pièce de câblage devant être réalisée par la mise en oeuvre de l'invention.

Les figures 8 à 12 illustrent schématiquement des étapes du procédé selon l'invention pour réaliser la pièce de câblage de la figure 1, ainsi que des parties du dispositif de l'invention pour la mise en oeuvre du procédé.

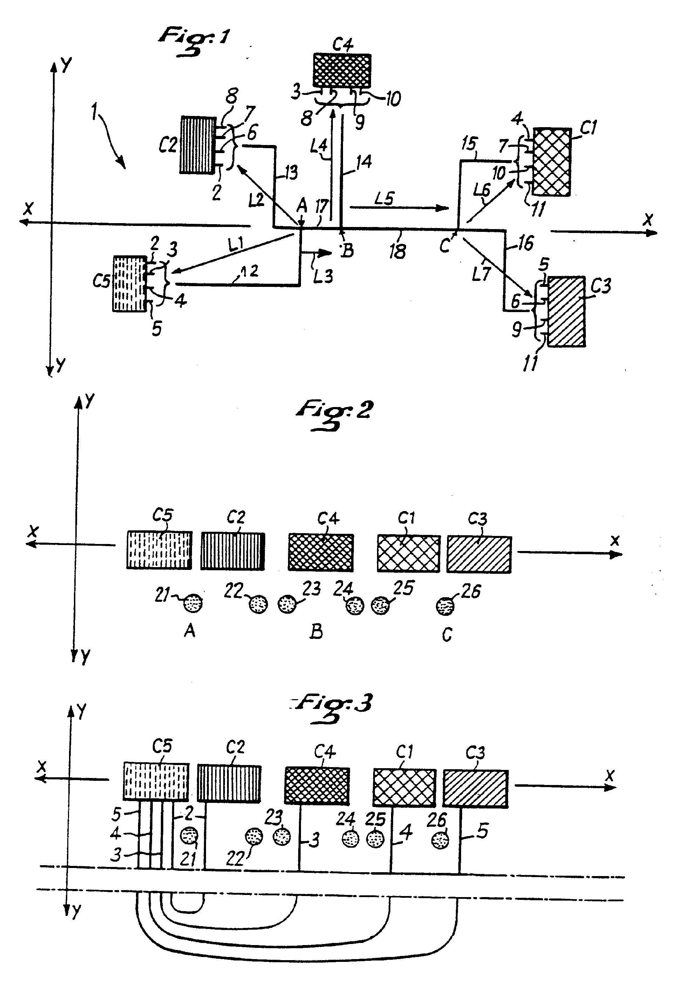

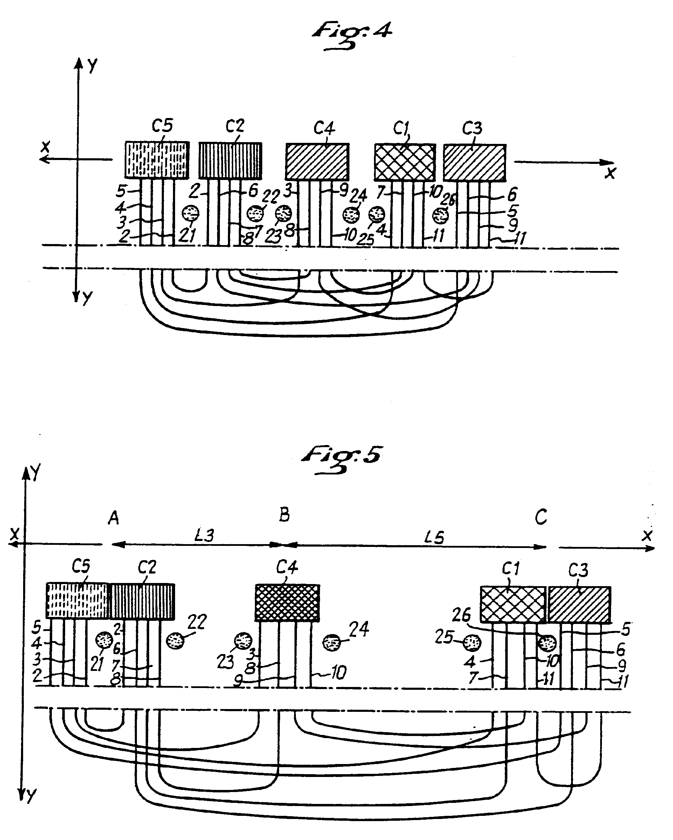

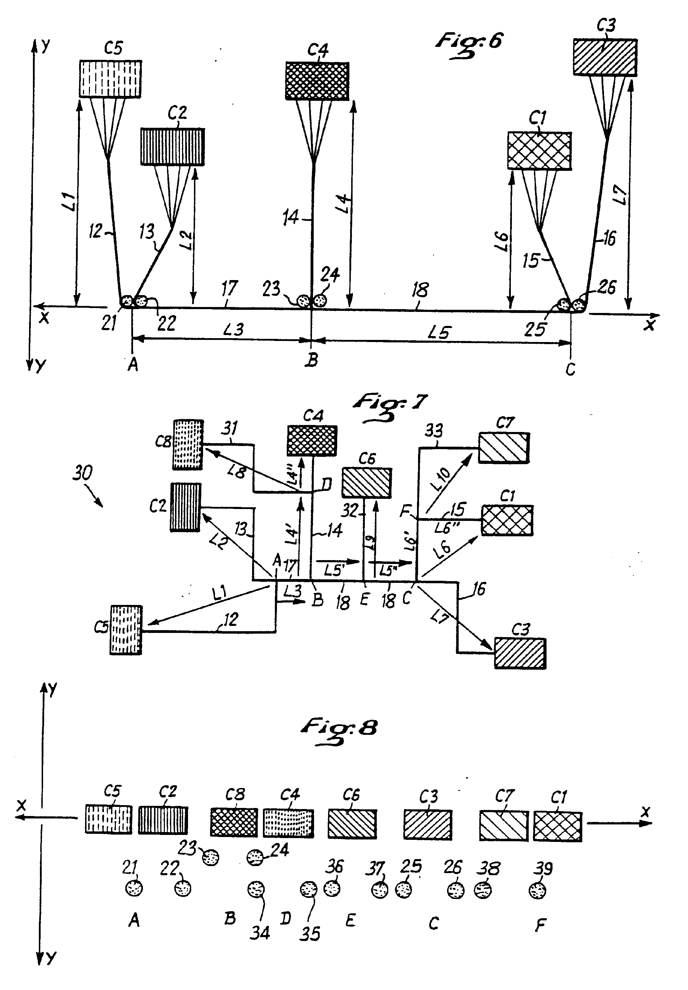

Dans le premier exemple particulier de mise en oeuvre de l'invention illustré schématiquement par les figures 1 à 6, on a supposé que la pièce de câblage 1 à réaliser (voir la figure 1) :
- comporte cinq connecteurs, respectivement référencés C1 à C5, comportant chacun quatre emplacements de branchement ; et
- chaque connecteur a une liaison électrique avec chacun des quatre autres.

Ainsi, dans ce mode de réalisation :
- un conducteur 2 relie un emplacement de branchement du connecteur C5 et un emplacement de branchement du connecteur C2 ;
- un conducteur 3 relie un emplacement de branchement du connecteur C5 et un emplacement de branchement du connecteur C4 ;
- un conducteur 4 relie un emplacement de branchement du connecteur C5 et un emplacement de branchement du connecteur C1 ;
- un conducteur 5 relie un emplacement de branchement du connecteur C5 et un emplacement de branchement du connecteur C3 ;
- un conducteur 6 relie un emplacement de branchement du connecteur C2 et un emplacement de branchement du connecteur C3 ;
- un conducteur 7 relie un emplacement de branchement du connecteur C2 et un emplacement de branchement du connecteur C1 ;
- un conducteur 8 relie un emplacement de branchement du connecteur C2 et un emplacement de branchement du conducteur C4 ;
- un conducteur 9 relie un emplacement de branchement du connecteur C4 et un emplacement de branchement du connecteur C3 ;
- un conducteur 10 relie un emplacement de branchement du connecteur C4 et un emplacement de branchement du connecteur C1 ; et
- un conducteur 11 relie un emplacement de branchement du connecteur C1 et un emplacement du branchement du connecteur C3.

Chacun des conducteurs 2 à 11 suit un cheminement déterminé.

Comme on peut le voir sur la figure 1, les connecteurs occupent des positions géographiques différentes, déterminées en fonction de la disposition des différents équipements à relier avec la pièce de câblage 1. Par ailleurs :
- les conducteurs 2,3,4 et 5 reliés au connecteur C5 sont rendus solidaires les uns des autres pour former un faisceau 12 ;
- les conducteurs 2,6,7,8 reliés au connecteur C2 sont rendus solidaires les uns des autres pour former un faisceau 13 ;
- les conducteurs 3,8,9,10 reliés au connecteur C4 sont rendus solidaires les uns des autres pour former un faisceau 14 ;
- les conducteurs 4,7,10,11 reliés au connecteur C1 sont rendus solidaires les uns des autres pour former un faisceau 15 ;
- les conducteurs 5,6,9,11 reliés au connecteur C3 sont rendus solidaires les uns des autres pour former un faisceau 16 ;
- les faisceaux 12 et 13 sont réunis en un point (ou noeud) A pour former un faisceau 17, comportant les conducteurs 3,4,5,6,7 et 8 ;
- les faisceaux 14 et 17 sont réunis en un point (ou noeud) B pour former un faisceau 18, comportant les conducteurs 4,5,6,7,9 et 10 ; et
- les faisceaux 15 et 16 sont réunis en un point (ou noeud) C pour former ledit faisceau 18.

Comme cela est usuel dans ce type de pièce de câblage, la pièce de câblage 1 est allongée dans une direction principale X-X, déterminée par les faisceaux 17 et 18 qui forment un faisceau longitudinal principal, les faisceaux 12,13,14,15 et 16 constituant des dérivations latérales par rapport au faisceau longitudinal principal 17-18 et les connecteurs C1 à C5 étant espacés de celui-ci, parallèlement à une direction transversale Y-Y.

On remarquera que les connecteurs C1,C2 et C4 sont disposés d'un côté du faisceau longitudinal principal 17-18 et que les connecteurs C3 et C5 sont disposés de l'autre côté de celui-ci. Par ailleurs, seul le faisceau latéral 14 est rectiligne ; les autres faisceaux latéraux 12,13,15 et 16 présentent une forme sinueuse.

On a désigné par L1,L2,L3,L4,L5,L6 et L7 respectivement les longueurs développées entre le connecteur C5 et le point A, entre le connecteur C2 et le point A, entre les points A et B, entre le connecteur C4 et le point B, entre les points B et C, entre le connecteur C1 et le point C, et entre le connecteur C3 et le point C.

On voit qu'ainsi la longueur de chaque conducteur 2 à 11 peut être exprimée à partir des longueurs L1 à L7.

Par exemple, la longueur développée du conducteur 2 est égale à L1 + L2, tandis que celle du conducteur 6 est égale à L2 + L3 + L5 + L7.

On peut donc, à partir d'un plan représentant la pièce de câblage 1 à la manière de la figure 1, préparer tous les conducteurs 2 à 11 à la bonne longueur, compte tenu bien sûr de la longueur de dénudage des extrémités de ceux-ci, nécessaire au branchement sur les connecteurs respectifs.

Pour réaliser la pièce de câblage 1 par la mise en oeuvre du procédé selon l'invention, on commence (voir la figure 2) par disposer lesdits connecteurs C1 à C5 les uns à côté des autres, par exemple pour former un alignement dans la direction X-X. Dans cet alignement, lesdits connecteurs sont disposés dans l'ordre dans lequel on les rencontre le long de l'axe X-X dans ladite pièce de câblage 1. De plus, on prévoit des pions mobiles 21 à 26, qui comme on peut le voir sur la figure 2, sont associés par paires, rapprochées les unes des autres et formant un alignement parallèle à la direction X-X. Comme on le verra ci-après, les pions mobiles 21 à 26 ont pour objet de déterminer la position des noeuds de jonction A,B et C. Les pions 21 et 22 sont associés au connecteur C2 et encadrent les emplacements de branchement de celui-ci. Les pions 23 et 24, d'une part, et 25 et 26 d'autre part, sont respectivement associés aux connecteurs C4 et C1, dans les mêmes conditions.

Les connecteurs C1 à C5 et les pions 21 à 26 étant dans les positions rapprochées relatives représentées sur la figure 2, on commence le branchement des différents conducteurs 2 à 11. Ainsi (voir la figure 3), le conducteur 2 est mis en place pour relier le connecteur C5 et le connecteur C2, ce conducteur 2 passant entre les pions 21 et 22 au voisinage du connecteur C2. De même, les conducteurs 3,4 et 5 sont branchés sur les connecteurs C5,C4,C1 et C3, les conducteurs 3 et 4 étant amenés à passer respectivement entre les pions 23 et 24 d'une part, et, 25 et 26, d'autre part, au voisinage des connecteurs C4 et C1.

On continue le branchement des différents conducteurs de sorte que, à la fin dudit branchement (voir la figure 4) :
- au voisinage du connecteur C2, les conducteurs 2,6,7 et 8 passent entre les pions 21 et 22 ;
- au voisinage du connecteur C4, les conducteurs 3,8,9 et 10 passent entre les pions 23 et 24 et ;
- au voisinage du connecteur C1, les conducteurs 4,7,10 et 11 passent entre les pions 25 et 26.

Lorsque ce branchement est terminé, on procède, comme cela est montré par la figure 5, à un premier déplacement relatif des connecteurs C1 à C5 et des paires de pions 21 à 26, par écartement le long de la direction X-X.

C'est ainsi que, à la fin de ce premier déplacement relatif:
- les connecteurs C5 et C2 restent proches l'un de l'autre et sont disposés au voisinage du noeud de jonction A, déterminé au moins approximativement par la paire de pions 21 et 22 ;
- le connecteur C4 et la paire de pions 23 et 24 se trouvent au voisinage du noeud de jonction B, déterminé au moins approximativement par lesdits pions 23 et 24 ; et
- les connecteurs C1 et C3 sont proches l'un de l'autre et sont disposés au voisinage du noeud de jonction C, déterminé au moins approximativement par la paire de pions 25 et 26.

Ensuite (voir la figure 6), les pions de chaque paire de pions sont rapprochés l'un de l'autre pour déterminer avec précision, entre eux, respectivement les noeuds de jonction A,B et C, après quoi les connecteurs C1 à C5 sont tirés parallèlement à la direction transversale Y-Y, d'un même côté du faisceau principal 17-18 jusqu'à ce que les conducteurs soient tendus. Lors de cette traction des connecteurs C1 à C5, les conducteurs 2 à 11 glissent sur les pions rapprochés de la paire de pions correspondante. Dans cette position relative, il est possible de rendre solidaires les uns des autres les conducteurs ayant des portions de cheminement communes pour former respectivement les faisceaux latéraux 12 à 16 et le faisceau principal 17-18 (situation représentée sur la figure 6).

A partir de la pièce de câblage intermédiaire représentée sur la figure 6, pour obtenir la pièce de câblage définitive 1, il suffit, par déformation, de faire passer les faisceaux 12 et 16 du côté opposé du faisceau principal 17-18 et de conformer à leur forme définitive les faisceaux 12,13,15 et 16.

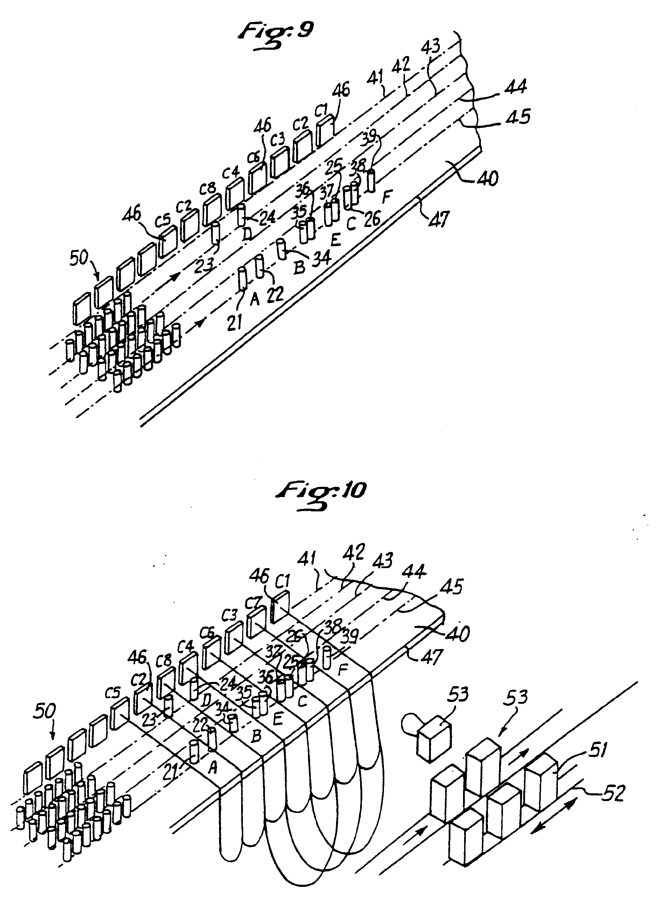

Dans la pièce de câblage 30, illustrée de façon simplifiée et schématique sur la figure 7, on retrouve la pièce de câblage 1, avec ses connecteurs C1 à C5, ses faisceaux 12 à 18 et ses noeuds de jonction A,B et C. La pièce de câblage 30 comporte de plus :
- un faisceau de dérivation 31, de longueur développée L8, aboutissant à un connecteur C8 et monté en dérivation sur le faisceau latéral 14, à partir d'un noeud de jonction D, disposé à une distance L4′ du noeud B et à une distance L4˝ du connecteur C4, avec L4′ + L4˝ = L4 ;
- un faisceau latéral supplémentaire 32, de longueur L9, aboutissant à un connecteur C6 et monté en dérivation sur le faisceau principal 17-18, à partir d'un noeud de jonction E, disposé à une distance L5′ du noeud B et à une distance L5˝ du noeud C, avec L5′ + L5˝ = L5 ; et
- un faisceau de dérivation 33, de longueur développée L10, aboutissant à un connecteur C7 et monté en dérivation sur le faisceau latéral 15, à partir d'un noeud de jonction F, disposé à une distance L6′ du noeud C et à une distance L6˝ du connecteur C1, avec L6′ + L6˝ = L6.

Dans une étape préparatoire à la réalisation de la pièce de câblage 30 (voir la figure 8 comparable à la figure 2), on forme l'alignement en position rapprochée des connecteurs C1 à C5, avec interposition des connecteurs C6,C7 et C8 et on prévoit les paires de pions 21 et 22, 23 et 24 et 25 et 26, respectivement pour la détermination des noeuds de jonction A B et C. On prévoit de plus des paires de pions 34-35, 36-37 et 38-39, respectivement associées aux connecteurs C8,C6 et C7 pour la détermination des noeuds D,E et F.

A des fins de simplification de montage et pour éviter des difficultés d'encombrement, lesdits pions peuvent être montés en plusieurs alignements parallèles.

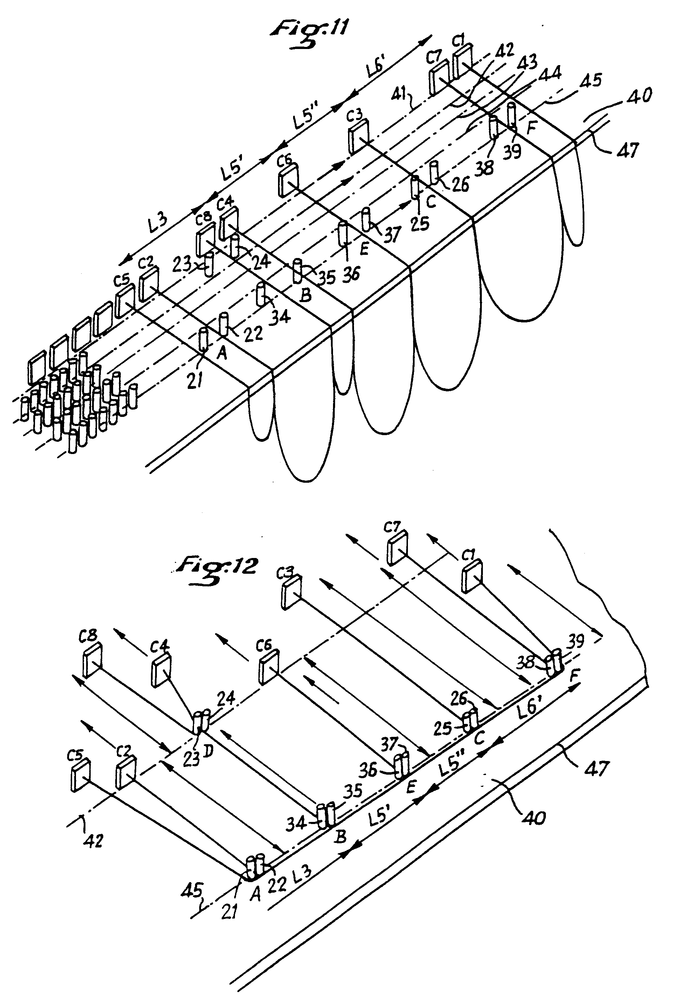

Comme cela est illustré schématiquement sur la figure 9, la machine pour mettre en oeuvre le procédé selon l'invention peut comporter un support plan 40, par exemple une table horizontale, pourvues de voies rectilignes de guidage parallèles 41 à 45, le long desquelles peuvent glisser des supports 46, maintenant chacun un connecteur C1 à C8, et les pions 21 à 26 et 34 à 39. A des fins de simplification, sur la figure 9, ainsi que sur les figures 10 à 12, chaque ensemble d'un support 46 et d'un connecteur C1 à C8 est représenté par une plaquette unique. Les supports 46 et lesdits pions peuvent être prélevés dans une réserve 50, disponible sur la table 40. La mise en place des supports 46 et des pions par coulissement le long des voies 41 à 45 et leurs déplacements relatifs ultérieurs peuvent être effectués manuellement ou sous l'action de moyens de déplacement non représentés. Dans ce dernier cas, ces moyens peuvent être associés à des robots, par exemple commandés par un calculateur. Sur la figure 9, on a représenté les connecteurs C1 à C8 et les pions 21 à 26 et 34 à 39 dans la position préparatoire de la figure 8.

De la même manière qu'il a été décrit en regard des figures 3,4 et 5, les différents conducteurs constituant la pièce de câblage 30 sont branchés par leurs deux extrêmités aux deux connecteurs correspondants, en passant à travers les paires de pions respectifs (voir la figure 10). Ces branchements peuvent être effectués par l'intermédiaire d'enficheurs automatiques 51, se déplaçant sur des voies 52, lesdits conducteurs étant amenés par une chaîne de transfert 53. Les déplacements des enficheurs 51 et de la chaîne de transfert 53 peuvent être parallèles aux voies de guidage 41 à 45 et commandés par ledit calculateur. Une caméra de surveillance 54 peut être prévue pour contrôler les opérations.

Pendant l'opération de branchement des conducteurs, alors que les connecteurs C1 à C8 et les pions 21 à 26 et 34 à 39 sont en position rapprochée, il est avantageux, afin d'éviter l'encombrement de la table horizontale 40, que la plus grande partie des boucles formées par lesdits conducteurs puissent prendre librement à l'extérieur de la table 40, à partir d'un bord 47 de celle-ci.

Ensuite (voir figure 11), les connecteurs C1 à C8 et les paires de pions sont écartés les uns des autres, le long des voies 41,42 et 45, de la même manière que celle montrée par la figure 5. Après quoi, les pions de chaque paire de pions sont resserrés pour délimiter avec précision les différents noeuds A à F, puis les supports 46 sont tirés transversalement aux voies 41 à 45 pour tendre les conducteurs respectifs (voir la figure 12). On peut alors solidariser lesdits conducteurs pour former les différents faisceaux, puis disposer et conformer ceux-ci de façon à obtenir la pièce de câblage 30 de la figure 7.

## Revendications

1. Procédé pour la réalisation d'une pièce de câblage (1) comportant une pluralité de conducteurs (2-11) et de connecteurs (C1-C5), lesdits connecteurs étant chacun pourvus d'emplacements de branchement pour des extrêmités de conducteurs et occupant dans ladite pièce de câblage des positions géographiques déterminées, tandis que chaque conducteur suit un cheminement déterminé à l'intérieur de ladite pièce de câblage pour relier un emplacement de branchement d'un connecteur à un emplacement de branchement d'un autre connecteur, les cheminements desdits conducteurs présentant des tronçons communs le long desquels lesdits conducteurs sont solidarisés les uns des autres en faisceaux (12-18), et ladite pièce de câblage présentant une structure allongée comprenant un faisceau longitudinal principal (17, 18) et des faisceaux latéraux (12-16) reliés à celui-ci à des noeuds de jonction (A, B, C),
caractérisé en ce que :
a) on prévoit des organes de guidage glissant (21-26), individuels et susceptibles de rassembler les conducteurs appartenant à un même faisceau et de séparer les uns des autres les conducteurs de faisceaux différents ;
b) on dispose lesdits connecteurs les uns à côté des autres, dans l'ordre dans lequel ils se trouvent le long dudit faisceau principal (17, 18) ;
c) on dispose les uns à côté des autres autant d'organes de guidage glissant (21-26) qu'il est nécessaire pour déterminer lesdits noeuds de jonction ;
d) on connecte les extrémités de chaque conducteur aux emplacements de branchement appropriés des deux connecteurs qui doivent être reliés par ledit conducteur, en faisant passer ce conducteur par le ou les organes de guidage glissant correspondants ;
e) on écarte lesdits organes de guidage glissant les uns des autres jusu'à ce qu'ils viennent en coïncidence avec lesdits noeuds de jonction des faisceaux latéraux au faisceau principal et on écarte lesdits connecteurs les uns des autres jusqu'à ce que lesdits conducteurs soient tendus ;
f) on rend solidaires les uns des autres les conducteurs appartenant à un même faisceau ; et
g) on dégage la pièce de câblage ainsi obtenue desdits organes de guidage glissant.

2. Procédé selon la revendication 1,
caractérisé en ce que l'on procède à une éventuelle opération de mise en forme ultérieure desdits faisceaux de façon que ceux-ci présentent leur forme définitive et que lesdits connecteurs viennent occuper les positions géographiques relatives qu'ils occupent dans ladite pièce de câblage.

3. Procédé selon l'une des revendications 1 ou 2,
caractérisé en ce que :
- dans l'opération b) lesdits connecteurs en position rapprochée les uns des autres forment au moins approximativement un alignement ;
- dans l'opération c) lesdits organes de guidage glissant en position rapprochée les uns des autres forment au moins approximativement un alignement ; et
- ledit alignement d'organes de guidage glissant est disposé au moins sensiblement parallèlement audit alignement de connecteurs.

4. Procédé selon la revendication 3,
caractérisé en ce que lesdits alignements de connecteurs et d'organes de guidage glissant sont au moins sensiblement parallèle audit faisceau longitudinal principal de la pièce de câblage à obtenir.

5. Procédé selon la revendication 4,
caractérisé en ce que, dans l'opération e), l'écartement desdits organes de guidage glissant se fait le long dudit alignement d'organes de guidage glissant, tandis que l'écartement desdits connecteurs se fait le long dudit alignement de connecteurs, ainsi que transversalement à ce dernier alignement.

6. Procédé selon la revendication 5,
caractérisé en ce que, quel que soit le côté du faisceau longitudinal principal où se trouvent lesdits faisceaux latéraux, ledit écartement transversal des connecteurs est réalisé d'un seul côté dudit alignement de connecteurs, les faisceaux latéraux devant se trouver du côté opposé étant ramenés du bon côté dans une opération ultérieure.

7. Procédé selon l'une quelconque des revendications 1 à 6, pour la réalisation d'une pièce de câblage dans laquelle au moins certains desdits faisceaux latéraux comportent des faisceaux de dérivation pourvus de connecteurs à leurs extrémités libres,
caractérisé en ce que l'on prévoit des organes de guidage glissant supplémentaires associés aux noeuds de jonction des faisceaux de dérivation aux faisceaux latéraux, et en ce que :
- dans l'opération b), les connecteurs reliés aux extrémités desdits faisceaux de dérivation sont intercalés parmi les connecteurs des faisceaux latéraux ;
- dans l'opération c), lesdits organes de guidage glissant supplémentaires sont disposés en position rapprochée les uns des autres en étant intercalés avec les autres organes de guidage glissant ;
- dans l'opération d), on fait passer les conducteurs concernés par les organes de guidage glissant supplémentaires et ;
- dans l'opération e), on écarte lesdites organes de guidage glissant supplémentaires les uns des autres par glissement le long desdits conducteurs jusqu'à ce qu'ils viennent en coïncidence avec lesdits noeuds de jonction entre les faisceaux de dérivation et les faisceaux latéraux.

8. Procédé selon la revendication 7 et l'une quelconque des revendications 3 ou 4,
caractérisé en ce que, dans l'opération c), lesdits organes de guidage glissant supplémentaires se trouvent, en position rapprochée, dans un alignement, ledit alignement étant soit celui des connecteurs, soit un alignement parallèle à celui-ci et à celui des organes de guidage glissant associés aux noeuds de jonction entre les faisceaux latéraux et le faisceau principal.

9. Procédé selon la revendication 8,
caractérisé en ce que, dans l'opération e), l'écartement desdits organes de guidage glissant supplémentaires se fait le long de l'alignement dans lequel ils se trouvent.

10. Dispositif pour la mise en oeuvre du procédé spécifié sous l'une quelconque des revendications 1 à 9,
caractérisé en ce qu'il comporte :
- un support,
- des organes de guidage glissant (21-26), individuels et susceptibles de guider les conducteurs (2-11) d'une pièce de cablage (1) et de se déplacer sur ledit support ; et
- des organes pour le maintien des connecteurs (C1-C5) de ladite pièce de cablage (1), lesdits organes de maintien étant susceptibles de se déplacer sur ledit support.

11. Dispositif selon la revendication 10,
caractérisé en ce qu'il comporte des moyens pour déplacer lesdits organes de guidage glissant et lesdits organes de maintien des connecteurs et des moyens pour brancher les extrémités desdits conducteurs sur les connecteurs.

12. Dispositif selon la revendication 10,
caractérisé en ce que ledit support est vertical.

13. Dispositif selon la revendication 10,
caractérisé en ce que ledit support est horizontal.

14. Dispositif selon la revendication 13,
caractérisé en ce que ledit support est tel qu'une partie de chaque conducteur reliée à deux connecteurs en position rapprochée ne soit pas supportée par ledit support et puisse pendre verticalement à l'extérieur de celui-ci.

15. Dispositif selon l'une quelconque des revendications 10 à 13,
caractérisé en ce qu'il comporte des moyens pour guider les déplacements desdits organes de guidage glissant et lesdits organes de maintien des connecteurs le long de trajectoires rectilignes parallèles.

16. Dispositif selon l'une quelconque des revendications 10 à 15,
caractérisé en ce que lesdits organes de guidage glissant sont constitués par des pions, utilisés par paires.

17. Dispositif selon l'une quelconque des revendications 10 à 15,
caractérisé en ce qu'il comporte des moyens pour couper à longueur, identifier et préparer chaque conducteur.

## Patentansprüche

1. Verfahren zur Verwirklichung eines Verdrahtungsteils (1) mit einer Vielzahl von Leitern (2-11) und Steckverbindern (C1-C5), wobei die Steckverbinder jeweils Anschlußstellen für Leiterenden haben und im Verdrahtungsteil räumlich bestimmte Stellungen einnehmen, während jeder Leiter innerhalb des Verdrahtungsteils zur Verbindung einer Anschlußstelle eines Steckverbindes mit einer Anschlußstelle eines anderes Steckverbinders einen bestimmten Verlauf hat, wobei der Verlauf der Leiter gemeinsame Abschnitte aufweist, über die die Leiter zu Bündeln (12-18) zusammengefaßt sind, und das Verdrahtungsteil eine längliche Struktur mit einem Hauptlängsbündel (17, 18) und Seitenbündeln (12-16) aufweist, die mit diesem über Knotenpunkte (A, B, C) verbunden sind, dadurch gekennzeichnet, daß:
a) individuelle Gleitführungsorgane (21-26) vorgesehen sind, durch die die Leiter eines Bündels zusammengefaßt und die Leiter unterschiedlicher Bündel voneinander getrennt werden können;
b) die Steckverbinder nebeneinander in der Reihenfolge angeordnet werden, in der sie sich längs des Hauptbündels (17, 18) befinden;
c) so viele Gleitführungsorgane (21-26) nebeneinander angeordnet werden, wie zur Bestimmung der Knotenpunkte benötigt werden;
d) die Enden jedes Leiters an die geeigneten Anschlußstellen der beiden durch den Leiter zu verbindenden Steckverbinder angeschlossen werden, wobei dieser Leiter durch das oder die entsprechenden Gleitführungsorgane verläuft;
e) die Gleitführungsorgane voneinander abgestellt werden, bis sie mit den Knotenpunkten zwischen Seitenbündeln und Hauptbündel zusammentreffen, und die Steckverbinder voneinander abgestellt werden, bis die Leiter gespannt sind;
f) die Leiter eines Bündels zusammengefaßt werden; und
g) das so erhaltene Verdrahtungsteil von den Gleitführungsorganen gelöst wird.

2. Verfahren nach Anspruch 1,
dadurch gekennzeichnet, daß eine eventuelle spätere Formgebung der Bündel erfolgt, so daß diese dann ihre endgültige Form aufweisen und die Steckverbinder die relative räumliche Stellung einnehmen, die sie im Verdrahtungsteil haben.

3. Verfahren nach einem der Ansprüche 1 oder 2,
dadurch gekennzeichnet, daß:
- bei Arbeitsgang b) die aneinander angestellten Steckverbinder zumindest annähernd eine Reihe bilden;
- bei Arbeitsgang c) die Gleitführungsorgane in aneinander angestellter Stellung zumindest annähernd eine Reihe bilden; und
- die Reihe der Gleitführungsorgane zumindest ungefähr parallel zur Reihe der Steckverbinder verläuft.

4. Verfahren nach Anspruch 3,
dadurch gekennzeichnet, daß die Reihe der Steckverbinder und die Reihe der Gleitführungsorgane zumindest annähernd parallel zum Hauptlängsbündel des zu realisierenden Verdrahtungsteils verlaufen.

5. Verfahren nach Anspruch 4,
dadurch gekennzeichnet, daß bei Arbeitsgang e) die Abstellung der Gleitführungsorgane längs der Reihe der Gleitführungsorgane erfolgt, während die Abstellung der Steckverbinder längs der Steckverbinderreihe sowie quer zu dieser Reihe erfolgt.

6. Verfahren nach Anspruch 5,
dadurch gekennzeichnet, daß die Abstellung der Steckverbinder in Querrichtung unabhängig von der Seite des Hauptlängsbündels, auf der sich die Seitenbündel befinden, auf einer einzigen Seite der Steckverbinderreihe erfolgt, wobei die Seitenbündel, die sich auf der entgegengesetzten Seite befinden müssen, in einem späteren Arbeitsgang auf die richtige Seite gebracht werden.

7. Verfahren nach einem der Ansprüche 1 bis 6 zur Verwirklichung eines Verdrahtungsteils, bei dem mindestens einige der Seitenbündel Abzweigbündel haben, deren freie Enden mit Steckverbindern versehen sind,
dadurch gekennzeichnet, daß zusätzliche Gleitführungsorganevorgesehen werden, die den Knotenpunkten zwischen den Abzweigbündeln und den Seitenbündeln zugeordnet sind, und dadurch, daß:
- bei Arbeitsgang b) die mit den Enden der Abzweigbündel verbundenen Steckverbinder zwischen den Steckverbindern der Seitenbündel angeordnet werden;
- bei Arbeitsgang c) die zusätzlichen Gleitführungsorgane aneinander angestellt zwischen den anderen Gleitführungsorganen angeordnet werden;
- bei Arbeitsgang d) die betreffenden Leiter durch die zusätzlichen Gleitführungsorgane verlaufen; und
- bei Arbeitsgang e) die zusätzlichen Gleitführungsorgane durch Gleiten längs der Leiter voneinander abgestellt werden, bis sie mit den Knotenpunkten zwischen den Abzweigbündeln und den Seitenbündeln zusammentreffen.

8. Verfahren nach Anspruch 7 und einem der Ansprüche 3 oder 4,
dadurch gekennzeichnet, daß sich bei Arbeitsgang c) die zusätzlichen Gleitführungsorgane aneinander angestellt in einer Reihe befinden, wobei die Reihe entweder die Steckverbinderreihe oder eine Reihe ist, die parallel zu dieser und zur Reihe der Gleitführungsorgane verläuft, die den Knotenpunkten zwischen den Seitenbündeln und dem Hauptbündel zugeordnet sind.

9. Verfahren nach Anspruch 8,
dadurch gekennzeichnet, daß bei Arbeitsgang e) die Abstellung der zusätzlichen Gleitführungsorgane längs der Reihe erfolgt, in der sie sich befinden.

10. Vorrichtung zur Anwendung des unter einem der Ansprüche 1 bis 9 näher bezeichneten Verfahrens,
dadurch gekennzeichnet, daß sie umfaßt:
- einen Träger,
- individuelle Gleitführungsorgane (21-26), mit denen die Leiter (2-11) eines Verdrahtungsteils (1) geführt werden und die auf dem Träger verschoben werden können; und
- Halteorgane der Steckvorrichtungen (C1-C5) von Verdrahtungsteil (1), wobei die Halteorgane auf dem Träger verschoben werden können.

11. Vorrichtung nach Anspruch 10,
dadurch gekennzeichnet, daß sie Mittel zur Verschiebung der Gleitführungsorgane und der Halteorgane der Steckerverbinder und Mittel zum Anschluß der Enden der Leiter an den Steckverbindern hat.

12. Vorrichtung nach Anspruch 10,
dadurch gekennzeichnet, daß der Träger vertikal ist.

13. Vorrichtung nach Anspruch 10,
dadurch gekennzeichnet, daß der Träger horizontal ist.

14. Vorrichtung nach Anspruch 13,
dadurch gekennzeichnet, daß der Träger derart ist, daß sich ein Teil jedes mit zwei aneinander angestellten Steckverbindern verbundenen Leiters nicht auf dem Träger befindet und vertikal außerhalb desselben herabhängen kann.

15. Vorrichtung nach einem der Ansprüche 10 bis 13,
dadurch gekennzeichnet, daß sie Mittel zur Führung der Bewegungen der Gleitführungsorgane und der Halteorgane der Steckverbinder längs von parallelen geradlinigen Strecken hat.

16. Vorrichtung nach einem der Ansprüche 10 bis 15,
dadurch gekennzeichnet, daß die Gleitführungsorgane aus paarweise eingesetzten Stiften bestehen.

17. Vorrichtung nach einem der Ansprüche 10 bis 15,
dadurch gekennzeichnet, daß sie Mittel zum Ablängen, zur Kennzeichnung und zur Vorbereitung jedes Leiters hat.

## Claims

1. Process for manufacturing a cable harness (1) including a plurality of conductors (2-11) and of connectors (C1 to C5), the said connectors being each furnished with connection points for ends of conductors and occupying defined geographical positions in the said cable harness, whereas each conductor follows a defined path within the said cable harness in order to connect a connection point of one connector to a connection point of another connector, the paths of the said conductors exhibiting common sections along which the said conductors are rendered integral with each other, into bundles (12-18), and the said cable harness exhibiting an elongate structure comprising a main longitudinal bundle (17, 18) and side bundles (12-16) connected to the latter at junction nodes (A, B, C), characterized in that:
a) sliding guide members (21-26) are provided, which are individual and capable of bringing together the conductors belonging to the same bundle and of separating the conductors of different bundles from each other;
b) the said connectors are arranged beside each other in the order in which they lie along the said main bundle (17, 18);
c) as many sliding guide members (21-26) as is necessary to define the said junction nodes are arranged beside each other;
d) the ends of each conductor are connected up to the appropriate connection points of the two connectors which are to be connected by the said conductor, by making this conductor pass via the corresponding sliding guide member or members;
e) the said sliding guide members are moved away from each other until they come into coincidence with the said junction nodes of the side bundles at the main bundle, and the said connectors are moved away from each other until the said conductors are taut;
f) the conductors belonging to the same bundle are rendered integral with each other; and
g) the cable harness thus obtained is disengaged from the said sliding guide members.

2. Process according to Claim 1, characterized in that an optional operation of subsequent shaping of the said bundles is carried out, so that they exhibit their final shape and so that the said connectors come to occupy the relative geographical positions which they occupy in the said cable harness.

3. Process according to one of Claims 1 or [sic] 2, characterized in that:
- in operation b), the said connectors in the close-together position form, at least approximately, an alignment;
- in operation c), the said sliding guide members in the close-together position form, at least approximately, an alignment; and
- the said alignment of sliding guide members is arranged, at least substantially, parallel to the said alignment of connectors.

4. Process according to Claim 3, characterized in that the said alignments of connectors and of sliding guide members are at least substantially parallel to the said main longitudinal bundle of the cable harness to be obtained.

5. Process according to Claim 4, characterized in that, in operation e), the moving-away of the said sliding guide members takes place along the said alignment of sliding guide members, whereas the moving-away of the said connectors takes place along the said alignment of connectors as well as transversely to the latter alignment.

6. Process according to Claim 5, characterized in that, on whatever side of the main longitudinal bundle the said side bundles lie, the said transverse moving-away of the connectors is performed on the same side of the said alignment of connectors, the side bundles which have to lie on the opposite side being brought back from the correct side in a subsequent operation.

7. Process according to any one of Claims 1 to 6, for manufacturing a cable harness in which at least some of the said side bundles include branch bundles furnished with connectors at their free ends, characterized in that additional sliding guide members, associated with the junction nodes for joining the branch bundles to the side bundles, are provided and in that:
- in operation b), the connectors connected to the ends of the said branch bundles are interspersed among the connectors of the side bundles;
- in operation c), the said additional sliding guide members are arranged in the close-together position, being interspersed with the other sliding guide members;
- in operation d), the relevant conductors are made to pass via the additional sliding guide members; and
- in operation e), the said additional sliding guide members are moved away from each other by sliding along the said conductors until they come into coincidence with the said junction nodes between the branch bundles and the side bundles.

8. Process according to Claim 7 and either of Claims 3 or [sic] 4, characterized in that, in operation c), the said additional sliding guide members lie, in the close-together position, in an alignment, the said alignment being either that of the connectors or an alignment parallel to it and to that of the sliding guide members associated with the junction node between the side bundles and the main bundle.

9. Process according to Claim 8, characterized in that, in operation e), the moving-away of the said additional sliding guide members takes place along the alignment in which they lie.

10. Device for implementing the process specified under any one of Claims 1 to 9, characterized in that it includes:
- a support;
- sliding guide members (21-26) which are individual and capable of guiding the conductors (2-11) of a cable harness (1) and of being moved over the said support; and
- members for retaining the connectors (C1-C5) of the said cable harness (1), the said retaining members being capable of being moved over the said support.

11. Device according to Claim 10, characterized in that it includes means for moving the said sliding guide members and the said connector-retaining members, and means for connecting the ends of the said conductors onto the connectors.

12. Device according to Claim 10, characterized in that the said support is vertical.

13. Device according to Claim 10, characterized in that the said support is horizontal.

14. Device according to Claim 13, characterized in that the said support is such that a part of each conductor, this part being connected to two connectors in the close-together position, is not supported by the said support and can hang vertically outside the latter.

15. Device according to any one of Claims 10 to 13, characterized in that it includes means for guiding the movements of the said sliding guide members and the said connector-retaining members along straight parallel trajectories.

16. Device according to any one of Claims 10 to 15, characterized in that the said sliding guide members are constituted by studs, used in pairs.

17. Device according to any one of Claims 10 to 15, characterized in that it includes means for cutting to length, for identifying and for preparing each conductor.
